# EUROPEAN PATENT APPLICATION

(11) **EP 4 538 430 A1**
(43) Date of publication of application: **16.04.2025**
(21) Application number: 23803651.1
(22) Date of filing: 27.06.2023
(51) Int. Cl.: C30B 29/06, B01J 7/02, C23C 16/448, C30B 25/14, F28C 3/08, F28D 7/16

(54) **GAS SUPPLY DEVICE**

(30) Priority: 09.05.2022 JP 2022077155
(71) Applicant: Toyoko Kagaku Co., Ltd., Kawasaki-city, Kanagawa 211-8502 (JP); Techno Boundary Co., Matsusaka-shi, Mie 515-0103 (JP)
(72) Inventor: MARUYA, Shuhei, Matsusakashi, Mie 5150103 (JP); MIURA, Mitsuyoshi, Kawasaki-city, Kanagawa 2118502 (JP)
(74) Representative: Müller-Boré & Partner Patentanwälte PartG mbB
(86) International application number: PCT/JP2023/023767
(87) International publication number: WO 2023/219179

(57) **Abstract**

A mixed gas that is composed of a component gas and a carrier gas is efficiently supplied with a compact device configuration. A mixed gas supply device (1A, 1B) includes: an evaporator (10) that heats a liquid component and the carrier gas to generate the mixed gas that is composed of the carrier gas and the component gas obtained by vaporizing the liquid component; and a cooler (30) that cools the mixed gas generated in the evaporator (10) and to supply a mixed gas that is composed of the carrier gas and the component gas whose supersaturated part is condensed and separated. The evaporator (10) includes a shell-and-tube-type heating mechanism. In a shell (11) of the evaporator (10), a carrier gas tube (16, 17) that has holes (16H, 17H) for bubbling of the carrier gas opened at multiple locations extends in the horizontal direction. A liquid component supply port (20) is provided at a lower portion of the shell (11) of the evaporator (10). A discharge port (23) that discharges the mixed gas that is composed of the carrier gas and the component gas obtained by vaporizing the liquid component is provided at an upper portion of the shell (11) of the evaporator (10). A lower portion of the cooler (30) is connected to the discharge port (23) of the evaporator (10) via a pipe (31).

## Description

### Technical Field

The present invention relates to a gas supply device, and more specifically to a gas supply device useful for supplying a mixed gas, often used in the semiconductor industry and the like, that is composed of a trichlorosilane gas and a hydrogen gas.

### Background Art

Conventionally, in the semiconductor industry and the like, a mixed gas that is composed of a carrier gas and a component gas is used. For example, a mixed gas that is composed of a trichlorosilane gas serving as a component gas and a hydrogen gas serving as a carrier gas is used in a process of manufacturing a semiconductor epitaxial silicon wafer.

As a supply device for supplying a mixed gas that is composed of a trichlorosilane gas and a hydrogen gas, a device in which a mixed gas that is composed of a supersaturated trichlorosilane gas and a hydrogen gas is introduced into a cooler, the supersaturated part of trichlorosilane is condensed and separated, and a mixed gas that is composed of a trichlorosilane gas at a saturating concentration and a hydrogen gas is discharged from the cooler is known (Patent Document 1). Also, in such a gas supply device, it is known that, to acquire a mixed gas that is composed of a supersaturated trichlorosilane gas and a hydrogen gas, liquid trichlorosilane and a hydrogen gas are introduced into an evaporator (Patent Document 2 and Patent Document 3). In the evaporator, the liquid trichlorosilane is vaporized while the hydrogen gas is being bubbled to generate the mixed gas that is composed of the trichlorosilane gas and the hydrogen gas.

### Citation List

### Patent Document

Patent Document 1: Japanese Patent No. 4542643
Patent Document 2: Japanese Patent No. 4505077
Patent Document 3: Japanese Patent No. 6503293

### Summary of Invention

### Technical Problem

In the aforementioned gas supply device, a heater-heating-type or jacket-type heating medium heating method is used as a heating method in the evaporator. However, there is a demand that the device configuration be more compact and the mixed gas that is composed of the supersaturated trichlorosilane gas and the hydrogen gas be generated efficiently.

### Solution to Problem

The present inventors have found that, by supplying liquid trichlorosilane from a lower portion of a shell of a shell-and-tube-type heater serving as an evaporator, extending a tube having holes for bubbling at multiple locations inside the shell, and bubbling a hydrogen gas in the liquid trichlorosilane, a mixed gas that is composed of a supersaturated trichlorosilane gas and a hydrogen gas can be generated efficiently, the supply amount of the mixed gas can be made stable especially in a case where stringent fluid level control in the shell is performed, and the evaporator can be made compact, thereby completing the present invention.

That is, the present invention provides a mixed gas supply device including:
an evaporator configured to heat a liquid component and a carrier gas to generate a mixed gas that is composed of the carrier gas and a component gas obtained by vaporizing the liquid component; and
a cooler configured to cool the mixed gas generated in the evaporator and to supply a mixed gas that is composed of the carrier gas and the component gas whose supersaturated part is condensed and separated,
wherein:
   the evaporator includes a shell-and-tube-type heating mechanism that includes a shell having a cylindrical shape of which an axis is parallel to a horizontal direction, and that includes, in the shell, a heating medium tube extending in a direction of the axis;
   in the shell of the evaporator, a carrier gas tube that has holes for bubbling of the carrier gas opened at multiple locations extends in the horizontal direction;
   a liquid component supply port is provided at a lower portion of the shell of the evaporator;
   a discharge port configured to discharge the mixed gas that is composed of the carrier gas and the component gas obtained by vaporizing the liquid component is provided at an upper portion of the shell of the evaporator; and
   a lower portion of the cooler is connected to the discharge port of the evaporator via a pipe and is connected to the liquid component supply port via a pipe, and a condensed liquid formed in the cooler returns to the shell of the evaporator through the liquid component supply port. Advantageous Effects of Invention

With a mixed gas supply device according to the present invention, since an evaporator including a shell-and-tube-type heating mechanism is used, a liquid component can be heated and vaporized efficiently. Furthermore, holes for bubbling of a carrier gas are opened at multiple locations in a carrier gas tube, which is provided in a shell of the evaporator including the shell-and-tube-type heating mechanism. Thus, a component gas obtained by vaporizing the liquid component can be taken into the bubbles of the carrier gas that were generated by bubbling, and a mixed gas that is composed of a supersaturated component gas and the carrier gas can thus be generated efficiently.

Accordingly, the evaporator can be downsized, the entire mixed gas supply device can have a compact configuration, and the supply amount of the mixed gas can be made stable by performing stringent fluid level control in the shell of the evaporator.

### Brief Description of Drawings

[Fig.1A] Fig. 1A is a configuration diagram of a mixed gas supply device 1A according to an embodiment.
[Fig. 1B] Fig. 1B is a configuration diagram of a mixed gas supply device 1B according to the embodiment.
[Fig. 2] Fig. 2 is an exploded view of an evaporator in the mixed gas supply device according to the embodiment.
[Fig. 3] Fig. 3 is a perspective view of a hydrogen-introducing-side tube plate of the mixed gas supply device according to the embodiment as viewed from an evaporator internal side.
[Fig. 4] Fig. 4 is a layout diagram of heating medium tubes in tube plate grooves.
[Fig. 5] Fig. 5 is a cut-out cross-sectional view of an observation window.
[Fig. 6] Fig. 6 is a plan view of carrier gas tubes as viewed from an evaporator lower surface side.

### Description of Embodiments

Hereinafter, the present invention will be described in detail with reference to the drawings. Note that, in each of the drawings, the same reference signs represent similar or identical components.

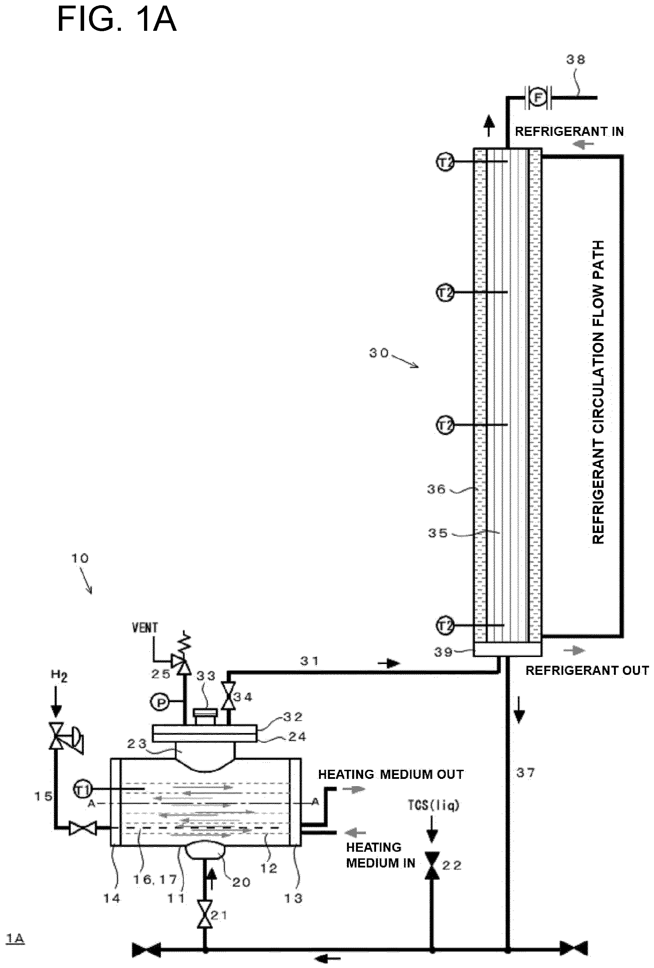

Fig. 1A is a configuration diagram of a mixed gas supply device 1A according to an embodiment of the present invention.

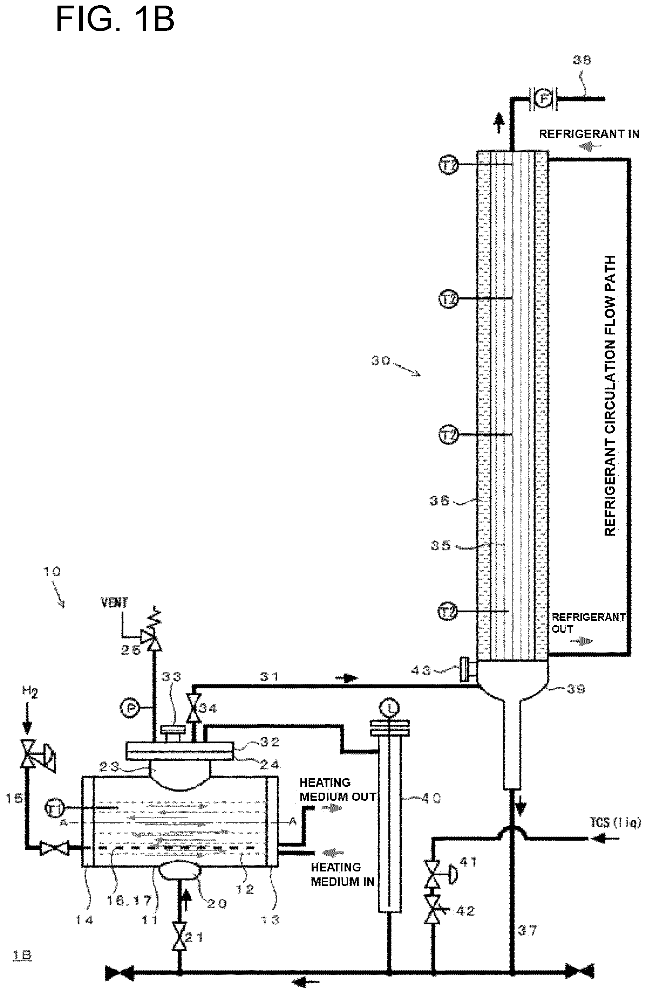

Fig. 1B is also a configuration diagram of a mixed gas supply device 1B according to the embodiment of the present invention. Herein, the mixed gas supply device 1B includes an evaporator 10 and a cooler 30 that are similar to those of the mixed gas supply device 1A, and Fig. 1B specifically illustrates an aspect of using a level sensor as a control unit for the liquid component amount in the evaporator 10.

These mixed gas supply devices 1A and 1B are suitably used to supply a mixed gas (hereinafter also referred to as a concentration regulated gas) that is composed of a trichlorosilane gas regulated to have a saturating concentration and a hydrogen gas. Each of the mixed gas supply devices 1A and 1B includes the evaporator 10 and the cooler 30.

The evaporator 10 is supplied with liquid trichlorosilane as a liquid component and a hydrogen gas as a carrier gas. By heating these components, the evaporator 10 vaporizes the liquid trichlorosilane to produce a trichlorosilane gas and generates a mixed gas that is composed of the trichlorosilane gas serving as a component gas and the hydrogen gas. In this mixed gas, trichlorosilane is in a supersaturated state.

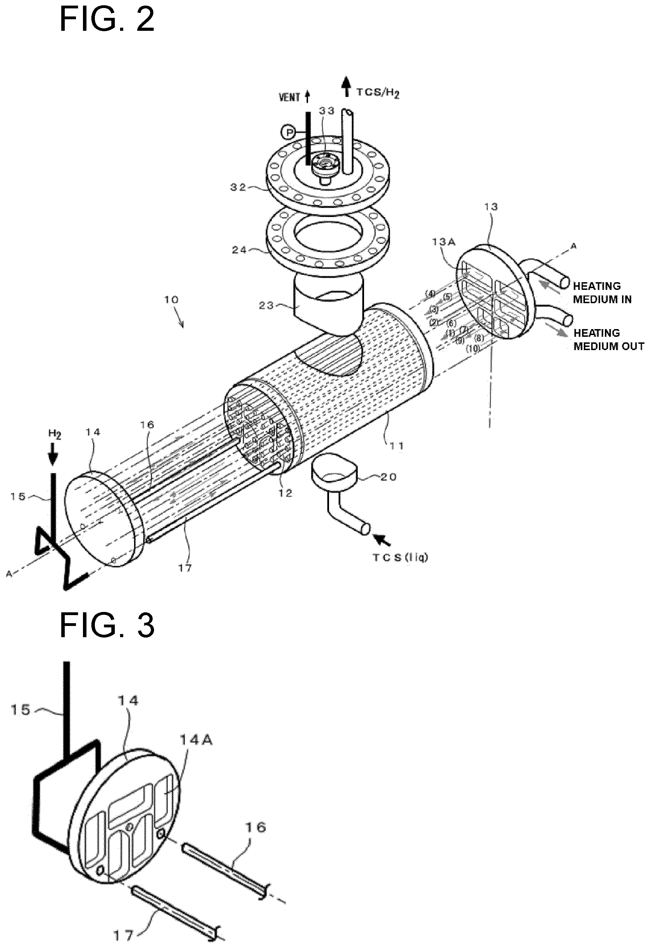

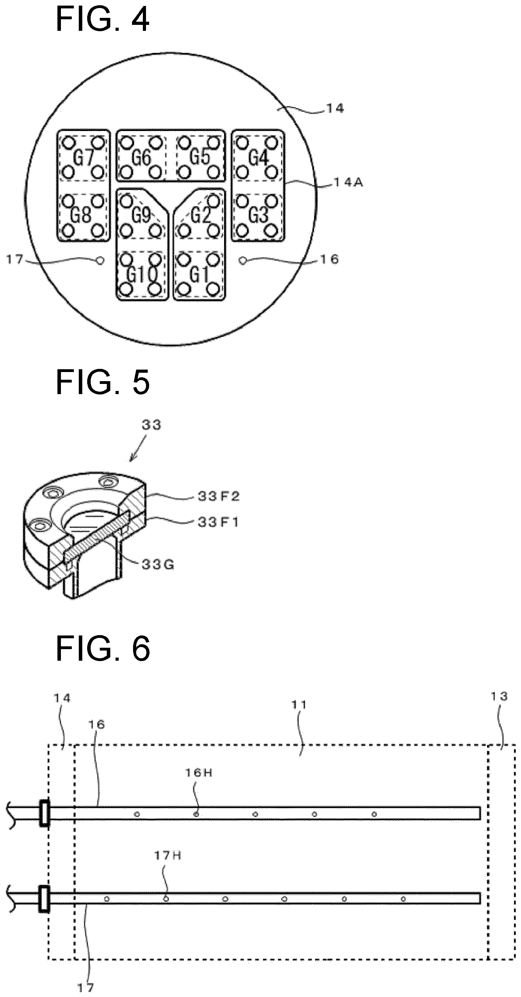

The evaporator 10 includes a shell-and-tube-type heating mechanism as a heating mechanism. That is, the evaporator 10 includes a cylindrical shell 11 of which an axis A is parallel to the horizontal direction and also includes, in the shell 11, multiple heating medium tubes 12 extending in the direction of the axis A. In the present invention, to raise heating efficiency in the evaporator 10, a heating medium is preferably caused to reciprocate between tube plates 13 and 14 on both sides of the shell 11 multiple times in a flow path formed by the multiple heating medium tubes 12. In this case, the multiple heating medium tubes are divided into multiple groups, and each of the groups is formed by multiple heating medium tubes so that an outgoing path or a return path of each cycle of the multiple reciprocations is formed by the multiple heating medium tubes. As a result, each group can serve as an outgoing flow path or a return flow path. For example, as illustrated by flowing directions of arrows (1) to (10) in Fig. 2, the heating medium flowing in from the tube plate 13 at one end of the shell 11 flows toward the tube plate 14 on the other end through the multiple heating medium tubes 12 of group 1 (arrow 1). Then, the heating medium flows from the tube plate 14 on the other end toward the tube plate 13 on the one end through the multiple heating medium tubes 12 of group 2 (arrow 2). Then again, the heating medium flows from the tube plate 13 toward the tube plate 14 on the other end through the multiple heating medium tubes 12 of group 3. This cycle is repeated to cause the heating medium to reciprocate five back-and-forth cycles between the tube plate 13 on the one end and the tube plate 14 on the other end using the heating medium tubes 12 of group 1 to group 10. In this case, the tube plate 13 on the one end is provided on the inside surface thereof with six tube plate grooves 13A while the tube plate 14 on the other end is provided on the inside surface thereof with five tube plate grooves 14A. These tube plate grooves serve to connect the flow paths of the outgoing groups to the flow paths of the return groups. Fig. 4 is a layout diagram of group 1 (G1) to group 10 (G10) of the heating medium tubes in the tube plate grooves 14A of the tube plate 14. Each of groups G1 to G10 is surrounded by the dotted line.

Note that, as the heating medium, a known inert material can be used, and examples thereof include Fluorinert (registered trademark) and Galden (registered trademark).

The heating medium is caused to take a flow path of reciprocating multiple times between the opposed tube plates 13 and 14 with use of the aforementioned heating medium tubes 12, and heat efficiency for heating the liquid component in the evaporator 10 is thus enhanced. Accordingly, the evaporator 10 can be downsized in the present invention. Therefore, for example, in a case where an 18 to 32% trichlorosilane gas is supplied from the cooler 30 to three channels at a flow rate of 16 g/min, the shell 11 of the evaporator 10 can be made compact by setting its size to 130 to 220 mm in external diameter and 350 to 500 mm in length in the direction of the axis A. As each of the heating medium tubes, a stainless steel tube having an internal diameter of about 20 mm can be used, for example. In this case, the temperature in the shell 11 is maintained by means of the heating medium at a predetermined temperature in a range of from 25 to 40°C, for example.

In each of the mixed gas supply devices 1A and 1B according to the present embodiment, the tube plates 13 and 14 of the shell-and-tube-type heating mechanism of the evaporator 10 are configured to be fixed tube plates, but in the present invention the tube plate of the shell-and-tube-type heating mechanism may be of a U-shaped type, a floating head type, or the like.

In the shell 11 of the evaporator 10, carrier gas tubes 16 and 17 extend in the horizontal direction. More specifically, a pipe 15 for supplying the hydrogen gas serving as a carrier gas is connected to the tube plate 14, and the two straight carrier gas tubes 16 and 17 are connected to the pipe 15. The tube plate 14 is provided with a thermometer T1 configured to measure the temperature in the shell 11 (Figs. 1A and 1B).

The carrier gas tubes 16 and 17 extend in the direction of the axis A from the tube plate 14 toward the opposed tube plate 13 in the vicinity of the bottom of the shell 11 and so as to be parallel to some of the lower tubes, out of the multiple heating medium tubes 12, thereby reaching the vicinity of the tube plate 13. Note that, although the carrier gas tubes 16 and 17 extend linearly from the tube plate 14 toward the tube plate 13 opposed to the tube plate 14 in the present embodiment, the present invention is not limited thereto. For example, the number of the carrier gas tubes may be three or more, and the carrier gas tubes may be bent. As mentioned before, the flow path of the heating medium travels in a reciprocating manner between the opposed tube plates 13 and 14 by means of the heating medium tubes 12 and the tube plate grooves 13A and 14A. On the other hand, the carrier gas tubes 16 and 17 extend from the tube plate 14, but do not reach the tube plate 13, and are closed at their respective tip ends. In this manner, the carrier gas tubes 16 and 17 are configured in straight-tube forms and have the tip ends thereof closed, allowing the configuration of the evaporator 10 to be more simplified.

As illustrated in Fig. 6, the carrier gas tubes 16 and 17 have downward holes 16H and 17H as holes for bubbling of the carrier gas, respectively. In the present invention, in a case where the multiple carrier gas tubes are arranged in parallel to one another at the lower portion of the shell 11 of the evaporator, the holes for bubbling of the carrier gas adjacent to each other are preferably formed in a staggered manner in the direction of the axis A of the shell 11 of the evaporator 10. Also, since the holes 16H and 17H face downward, bubbles of the carrier gas discharged from the holes 16H and 17H come in contact with the liquid component stored in the shell 11 for a longer period of time. This effect facilitates the process of the component gas obtained by vaporizing the liquid component being taken into the bubbles.

On the other hand, a liquid component supply port 20 is formed at the center in the direction of the axis A at the lower portion of the shell 11 of the evaporator 10, and the liquid trichlorosilane serving as the liquid component flows through an evaporator lower end valve 21 and is supplied from the liquid component supply port 20 into the shell 11. That is, in the mixed gas supply device 1A illustrated in Fig. 1A, liquid trichlorosilane that is forcibly fed and supplied from a liquid component makeup valve 22 flows through the evaporator lower end valve 21 and is supplied to the liquid component supply port 20. Furthermore, in the mixed gas supply device 1B illustrated in Fig. 1B, the liquid trichlorosilane is supplied by a low-pressure automatic valve 41. Note that, in Fig. 1B, reference sign 42 represents a needle valve that controls the flow rate. The opening degree of the needle valve 42 is controlled to the extent that the fluid level in the shell 11 does not fluctuate when the liquid trichlorosilane is supplied by the low-pressure automatic valve 41.

In each of the mixed gas supply devices 1A and 1B, the liquid trichlorosilane condensed in the cooler 30 is also supplied into the shell 11 by flowing through a pipe 37, the evaporator lower end valve 21, and the liquid component supply port 20.

It is preferable that the liquid quantity in the shell 11 is detected and properly controlled by providing a fluid level measuring instrument between the liquid component supply port 20 and the lower end of the cooler 30. As a preferable control unit for the liquid quantity, in the mixed gas supply device 1B illustrated in Fig. 1B, a discharge port 23 and the liquid component supply port 20 of the evaporator 10 are connected via a connecting tube 40, and a level sensor L is provided inside the connecting tube 40. Furthermore, the fluid level detected by the level sensor L is made to be within a predetermined range that is above all the heating medium tubes 12 in the shell 11. The detected fluid level is preferably made to be within a range in which the fluctuation range of the fluid level is within 10% of the upper limit of the fluid level, and more preferably as stable as possible. That is, when the level sensor L detects the fluid level at a preset lower limit value, the low-pressure automatic valve 41 automatically opens, and the liquid trichlorosilane is supplied into the liquid component supply port 20 at a flow rate that prevents the fluid level in the shell 11 from fluctuating, which is controlled by the needle valve 42. Here, in a case where the needle valve 42 is provided upstream of the low-pressure automatic valve 41, the liquid stored between the needle valve 42 and the low-pressure automatic valve 41 may flow into the shell 11 all at once when the low-pressure automatic valve 41 opens, causing the fluid level in the shell 11 to fluctuate, which is not preferable. By keeping the fluid level in the shell 11 within the predetermined range in which all of the heating medium tubes 12 are immersed in the liquid trichlorosilane and limiting the fluctuation range of the fluid level, the heat transfer amount from the heating medium tubes 12 to the liquid trichlorosilane will be constant, the evaporation amount of the liquid trichlorosilane will be stable, and the discharge amount of the mixed gas will be stable. Conversely, in a case where the heating medium tubes 12 are exposed from the liquid trichlorosilane in the shell 11, or where the fluid level in the shell 11 is not stable, the evaporation amount of the liquid trichlorosilane cannot be made stable, and the discharge amount of the mixed gas will not be stable.

The level sensor L is preferably of a capacitive type from a viewpoint of not having a movable portion.

Also, the connecting tube 40 is preferably provided adjacent to the evaporator 10 to make the total amount of the liquid trichlorosilane as small as possible. Thereby, the evaporation amount of the liquid trichlorosilane per heat transfer amount from the heating medium tubes 12 can be increased.

Note that direct provision of the level sensor inside the shell 11 as a method to detect the fluid level in the shell 11 is not preferable since the fluid level fluctuates because of the bubbling of the hydrogen gas in the shell 11 to make it impossible to detect the fluid level accurately. In addition, the direct provision is not preferable in that it is difficult to secure a space to provide the level sensor inside the shell 11 since the multiple heating medium tubes 12 are disposed therein.

The discharge port 23 is formed at the center in the direction of the axis A of the shell 11 of the evaporator 10 and at the upper portion thereof. The discharge port 23 is configured to discharge the mixed gas that is composed of the component gas and the carrier gas. Here, the component gas is generated by vaporization of the liquid component in the shell 11 and the carrier gas is bubbled from the holes 16H and 17H of the carrier gas tubes. An opening diameter L1 of the discharge port 23 for the mixed gas is preferably 50 to 100% of an internal diameter L2 of the shell, and more preferably 60 to 80%, from a viewpoint of fitting a pressure meter P, a safety valve, a pipe 31, and an observation window 33 in the area of the opening diameter and making the evaporator 10 compact.

The discharge port 23 for the mixed gas includes a flange 24 at a connecting portion to the pipe 31 connected to the lower portion of the cooler 30. The pipe 31 connected to the lower portion of the cooler 30 is also provided with a flange 32, and the flange 32 and the aforementioned flange 24 are connected to each other. At a portion surrounded by the flange 32, the observation window 33 for observing the inside of the shell 11 of the evaporator 10 is provided. The observation window 33 is formed by interposing an optically polished transparent tempered glass 33G between a flange 33F1 and a presser flange 33F2 (Fig. 5). To shield the inside of the shell 11 from external air, an appropriate sealing member is preferably interposed between the two flanges 33F1 and 33F2. The observation window 33 preferably has a diameter of 20 to 40 mm**.** This facilitates visual observation of a bubbling state of the carrier gas inside the shell 11.

At the portion surrounded by the flange 32, the pressure meter P configured to measure the pressure inside the shell 11 of the evaporator 10, a pressure regulator, and a control valve are provided to adjust the pressure inside the shell 11 to, for example, 0.09 to 0.17 MPa (G). In addition, in case of a pressure increase caused by an unforeseen factor, a pressure release valve 25 configured to release gases existing inside the shell 11 is provided.

Also, the aforementioned pipe 31 is provided with a gate valve 34. By providing the gate valve 34, the mixed gas supply devices 1A and 1B are not categorized as a "pressure vessel" stipulated by laws and regulations and are easy to handle.

The mixed gas discharged from the discharge port 23 of the evaporator 10 is supplied to a lower end portion 39 of the cooler 30 through the pipe 31.

In the present invention, the cooler 30 can be made similar to each of the coolers described in Patent Documents 2 and 3 and can be a shell-and-tube-type heat exchanger, for example. That is, the cooler 30 includes multiple tubes 35 through which the mixed gas from the evaporator 10 passes and a flow path 36 for a refrigerant that flows around the multiple tubes 35. In addition, thermometers T2 are provided at multiple locations in the tubes 35 through which the mixed gas passes, and these thermometers monitor the temperature. The refrigerant flows from the upper stage to the lower stage of the cooler 30 and keeps the temperature inside the cooler 30 at, for example, 10 to 20°C. In particular, since the concentration of the component gas at a concentration regulated gas supply port 38 is determined by the pressure and the condensation temperature of the system, the temperature of the refrigerant supplied to the upper stage of the cooler 30 is preferably kept within a predetermined range (preferably, ±0.1°C) by a chiller.

While passing through the tubes 35, the mixed gas discharged from the evaporator 10 is cooled by the refrigerant that flows through the flow path 36, and the supersaturated part of trichlorosilane is condensed and separated. To observe the condensation and separation state of the trichlorosilane, an observation window 43 for observing the inside of the lower end portion of the cooler may be provided at the lower end portion 39 of the cooler 30 as illustrated in Fig. 1B. The configuration of the observation window 43 can be made similar to that of the observation window 33 provided on the discharge port 23 of the evaporator 10.

The liquid trichlorosilane that has been condensed and separated flows from the lower end portion of the cooler 30 through the pipe 37 and is fed to the liquid component supply port 20 of the evaporator 10.

On the other hand, from the concentration regulated gas supply port 38 at the upper end portion of the cooler 30, a mixed gas that is composed of a trichlorosilane gas at a saturating concentration and a hydrogen gas is supplied as the concentration regulated gas. The concentration regulated gas supply port 38 is provided with a flowmeter F and a concentration meter, and the discharge amount of the mixed gas from the evaporator 10 to the cooler 30 is controlled according to the supply amount of the concentration regulated gas.

In this manner, with the mixed gas supply devices 1A and 1B according to the present embodiment, the mixed gas that is composed of the hydrogen gas and the trichlorosilane gas regulated to have a predetermined saturating concentration can be supplied with high concentration stability, and a compact device configuration can be achieved.

Note that the mixed gas supply device according to the present invention can suitably be used to supply not only the mixed gas that is composed of the trichlorosilane gas and the hydrogen gas but also a mixed gas that is composed of a tetrachlorosilane gas and a hydrogen gas, a mixed gas that is composed of a trichlorosilane gas and an argon gas, a mixed gas that is composed of a methyltrichlorosilane gas and a hydrogen gas, or the like.

### Reference Signs List

1A, 1B mixed gas supply device
10 evaporator
11 shell
12 heating medium tube
13 tube plate
13A tube plate groove
14 tube plate
14A tube plate groove
15 pipe
16 carrier gas tube
16H hole for bubbling of carrier gas
17 carrier gas tube
17H hole for bubbling of carrier gas
20 liquid component supply port
21 evaporator lower end valve
22 liquid component makeup valve
23 discharge port
24 flange
25 pressure release valve
30 cooler
31 pipe
32 flange
33 observation window for observing inside of shell of evaporator
34 gate valve
35 tube
36 flow path for refrigerant
37 pipe
38 concentration regulated gas supply port
39 lower end portion of cooler
40 connecting tube
41 low-pressure automatic valve
42 needle valve
43 observation window for observing inside of lower end portion of cooler
A axis
F flowmeter
L level sensor
P pressure meter
T1, T2 thermometer

## Claims

1. A mixed gas supply device comprising:
an evaporator configured to heat a liquid component and a carrier gas to generate a mixed gas that is composed of the carrier gas and a component gas obtained by vaporizing the liquid component; and
a cooler configured to cool the mixed gas generated in the evaporator and to supply a mixed gas that is composed of the carrier gas and the component gas whose supersaturated part is condensed and separated,
wherein:
the evaporator includes a shell-and-tube-type heating mechanism that includes a shell having a cylindrical shape of which an axis is parallel to a horizontal direction, and that includes, in the shell, a heating medium tube extending in a direction of the axis;
in the shell of the evaporator, a carrier gas tube that has holes for bubbling of the carrier gas opened at multiple locations extends in the horizontal direction;
a liquid component supply port is provided at a lower portion of the shell of the evaporator;
a discharge port configured to discharge the mixed gas that is composed of the carrier gas and the component gas obtained by vaporizing the liquid component is provided at an upper portion of the shell of the evaporator; and
a lower portion of the cooler is connected to the discharge port of the evaporator via a pipe and is connected to the liquid component supply port via a pipe, and a condensed liquid formed in the cooler returns to the shell of the evaporator through the liquid component supply port.

2. The mixed gas supply device according to claim 1, wherein:
the discharge port and the liquid component supply port of the evaporator are connected via a connecting tube;
a level sensor configured to detect a fluid level in the evaporator is provided inside the connecting tube; and
the liquid component is supplied to the liquid component supply port so that the fluid level detected by the level sensor is made to be above all the heating medium tubes in the shell.

3. The mixed gas supply device according to claim 2, wherein the connecting tube is provided adjacent to the evaporator.

4. The mixed gas supply device according to claim 2 or **3,** comprising a low-pressure automatic valve so as to automatically supply the liquid component to the liquid component supply port.

5. The mixed gas supply device according to claim 1 or **2,** wherein the carrier gas tube extends from one tube plate toward a tube plate opposed to the one tube plate in the direction of the axis of the shell of the evaporator.

6. The mixed gas supply device according to claim 1 or 2, wherein the carrier gas tube has holes opened downward as the holes for bubbling of the carrier gas.

7. The mixed gas supply device according to claim 6, wherein:
the carrier gas tube includes a plurality of carrier gas tubes that are arranged in parallel to one another at the lower portion in the shell; and
the holes for bubbling of the carrier gas tubes adjacent to each other are formed in a staggered manner in the direction of the axis of the shell of the evaporator.

8. The mixed gas supply device according to any one of claims 1 to 3, wherein an opening diameter of the discharge port of the evaporator is 50% or more of an internal diameter of the shell.

9. The mixed gas supply device according to any one of claims 1 to 3, wherein the heating medium flowing through the heating medium tube reciprocates between tube plates on both ends of the shell multiple times from introduction into the shell to discharge therefrom.

10. The mixed gas supply device according to any one of claims 1 to 3, wherein an observation window for observing an inside of the shell of the evaporator is provided at a connecting portion of the discharge port of the evaporator to a pipe that extends from the lower portion of the cooler.

11. The mixed gas supply device according to any one of claims 1 to 3, wherein an observation window for observing an inside of a lower end portion of the cooler is provided at the lower portion of the cooler.

12. The mixed gas supply device according to any one of claims 1 to 3, wherein the liquid component is liquid trichlorosilane and the carrier gas is a hydrogen gas.
